# EUROPÄISCHE PATENTSCHRIFT

(11) **EP 0 755 067 B1**
(45) Veröffentlichungstag und Bekanntmachung des Hinweises auf die Patenterteilung: **22.09.1999**
(21) Anmeldenummer: 96111249.7
(22) Anmeldetag: 11.07.1996
(51) Int. Cl.: H01L 21/033

(54) **Verfahren zur Herstellung von sublithographischen Ätzmasken**
Method of fabrication for sublithographic etching masks
Procédé pour la fabrication de masques sublithographiques pour la gravure

(30) Priorität: 17.07.1995 DE 19526011
(43) Veröffentlichungstag der Anmeldung: 22.01.1997
(73) Patentinhaber: SIEMENS AKTIENGESELLSCHAFT, 80333 München (DE)
(72) Erfinder: Kerber, Martin, Dr. rer. nat., 81827 München (DE)

(56) Entgegenhaltungen:
- US-A- 4 358 340
- US-A- 4 432 132
- US-A- 4 502 914
- US-A- 5 110 760
- PATENT ABSTRACTS OF JAPAN vol. 013, no. 226 (E-763), 25.Mai 1989 & JP-A-01 035916 (HITACHI LTD), 7.Februar 1989,

## Beschreibung

Die Erfindung betrifft ein Verfahren zur Herstellung von sublithographischen Ätzmasken zur Strukturerzeugung bei Halbleiterprodukten mit hoher Integrationsdichte.

Bei Halbleiterprodukten mit extrem hoher Integrationsdichte, beispielsweise bei integrierten Halbleiterspeichern, ist vielfach die Strukturfeinheit der Photolithographie der limitierende Faktor. Bei einer bestimmten Photolithographie-Generation mit der minimalen Strukturfeinheit F (feature size) ergibt sich die Größe des kleinsten Elements einer periodischen Anordnung aus (2 x F)² = 4 F².

Ein Ansatz zur Erhöhung der Packungsdichte von Speicherzellen ist die vertikale Anordnung der Speicherzellen. Diese werden auch als 3-D Sidewall Flash EPROM Zellen bezeichnet. Dabei wird das aktive Bauelement als ein Zylinder ausgeführt, wobei um diesen Zylinder ein erster isolierter Polyspacer (Floating Gate) ausgeführt ist. Dieser ist von einem Interpolydielektrikum umgeben und durch einen weiteren Polyring (Control Gate) umgeben. Durch die vertikale Anordnung entfällt das laterale Isolationsoxid. Durch eine geeignete Anordnung der Zylinder erreicht man eine selbstjustierte Wortleitung durch Zusammenwachsen der Control Gates in eine Richtung, während sie orthogonal dazu getrennt sind. Die Minimierung der Größe der Rasterperiode der Zylinder ist jedoch durch die Strukturfeinheit der Photolithographietechnik begrenzt.

Der Erfindung liegt die Aufgabe zugrunde, ein Verfahren zur Herstellung von sublithographischen Ätzmasken mit besonders kleinen Strukturen zu schaffen.

Die Lösung dieser Aufgabe erfolgt mit den Merkmalen des Anspruchs 1. Vorteilhafte Weiterbildungen der Erfindung sind in den Unteransprüchen beschrieben.

Die Bildung von Strukturen, deren Ausdehnung in einer Dimension kleiner als die photolithographische Auflösung ist, mit Hilfe von Spacern ist aus des Druckschrift JP-A-1 035 916 bekannt. In sich geschlossene Strukturen beschreibt die Druckschrift US-A- 5 110 760.

Nach dem Grundgedanken der Erfindung wird eine Spacertechnik zur Erzeugung subphotolithographischer Linien zweimal ausgeführt, wobei sich die Linien schneiden. Die Kreuzungspunkte bilden ein Raster von extrem kleinen Atzmasken. Die Größe der Atzmasken ist durch die Schichtdicke der Spacertechnik und nicht durch die Strukturfeinheit der Phototechnik bestimmt. Dabei entsteht eine Struktur mit sich periodisch wiederholenden Elementen, deren Länge nur etwas größer als die Struktureinheit F ist. Daraus ergibt sich eine minimale Zellfläche von ungefähr F² gegenüber 4 F² mit konventionellen Verfahren.

Im einzelnen wird bei dem Verfahren zur Herstellung von sublithographischen Ätzmasken zur Strukturerzeugung bei Halbleiterprodukten mit hoher Integrationsdichte zunächst auf einem Halbleitersubstrat eine Oxidschicht und darauf eine Siliziumschicht erzeugt. Auf der Siliziumschicht wird eine Hilfsschicht aufgebracht, die dann bahnenweise strukturiert wird. An den Flanken der so strukturierten Hilfsschicht wird ein erster Spacer erzeugt und anschließend die Hilfsschicht entfernt. Die Siliziumschicht wird dann unter Verwendung des ersten Spacers als Maske teilweise entfernt, woraufhin anschließend der erste Spacer entfernt wird. Dann wird eine weitere Hilfsschicht aufgebracht und bahnenweise strukturiert, wobei diese Bahnen in eine andere Richtung als die ersten Bahnen ausgerichtet werden und dabei Kreuzungsbereiche zwischen den ersten und zweiten Bahnen gebildet werden. An den Flanken der so strukturierten Hilfsschicht wird ein zweiter Spacer erzeugt und anschließend diese zweite Hilfsschicht entfernt. Die Siliziumschicht wird jetzt in einer zweiten Ätzung unter Verwendung des zweiten Spacers als Maske vollständig entfernt. Dann werden die zweiten Spacer entfernt und die vorher unter dem zweiten Spacer befindliche Siliziumschicht soweit entfernt, daß die Bereiche außerhalb der erhöhten Kreuzungsbereiche vollständig entfernt werden und von den erhöhten Kreuzungsbereichen nur ein Rest verbleibt. Anschließend wird die unter der Siliziumschicht liegende Oxidschicht unter Verwendung der Kreuzungsbereiche als Maske strukturiert. Die so geätzte Oxidschicht wird dann als Ätzmaske für die eigentliche Strukturerzeugung in der Siliziumschicht genutzt.

Durch dieses Verfahren läßt sich eine Struktur mit einer minimalen Zellfläche herstellen, die viermal kleiner ist als die mit dem konventionellen Photolithographieverfahren erzeugte Struktur.

Bevorzugt werden die Hilfsschichten durch Abscheidung von Siliziumoxid aus TEOS (Tetraethyloxysilikat) erzeugt und photolithographisch strukturiert. Die Verwendung von TEOS ist günstig, da so die Hilfsschicht oder-die strukturierten Bahnen später isotrop durch naßchemisches Ätzen entfernt werden können, da als darunter liegende Schicht bevorzugt amorphes Silizium oder polykristallines Silizium verwendet wird. Die Strukturierung der Hilfsschichten erfolgt bevorzugt mit der konventionellen Photolithographie, wobei jedoch durch das erfindungsgemäße Verfahren erreicht wird, daß die später wirklich verwendeten Atzmasken an den Eckpunkten der photolithographisch erzeugten Strukturen liegen und auf diese Weise eine Flächenverkleinerung von fast einem Faktor 4 erreicht wird.

Die Spacer werden günstigerweise durch konforme Abscheidung von Nitrid an den Flanken der jeweiligen strukturierten Hilfsschicht und anschließende anisotrope Ätzung erzeugt. Die Strukturbreite des entstehenden Spacers ist nicht mehr durch die Phototechnik, sondern durch den Abscheidungsprozeß bestimmt. Die Spacertechnik ermöglicht wesentlich feinere Strukturen von bis zu 20 nm. Der Spacer entsteht dabei an jeder Kante der Hilfsstruktur.

Besonders bevorzugt ist es in dem erfindungsgemäßen Verfahren, die Siliziumschicht im ersten Ätzprozeß durch anisotrope Ätzung zu ca. 2/3 zu entfernen. Mindestens die Hälfte der Siliziumschicht sollte in diesem ersten Ätzprozeß entfernt werden, um in den späteren Ätzprozessen die erfindungsgemäßen Kreuzungsbereiche als Ätzmaske erzeugen zu können.

Die ersten Spacer werden bevorzugt mit der gleichen Breite wie die zweiten Spacer erzeugt. Dadurch ergeben sich nach Abschluß der verschiedenen Ätzschritte der Siliziumschicht Kreuzungsbereiche mit jeweils der gleichen Seitenlänge. Wenn außerdem noch die ersten und zweiten strukturierten Bahnen der Hilfsschicht orthogonal zueinander ausgerichtet sind, ergeben sich quadratische Kreuzungsbereiche. Mitunter kann es auch günstiger sein, Spacerbreite und Ausrichtung der Bahnen zueinander so festzulegen, daß die Kreuzungsbereiche Rechteck- oder Rautenform haben.

In einer bevorzugten Weiterentwicklung der Erfindung werden die zweiten Bahnen mit einer anderen Breite als die ersten Bahnen der Hilfsschicht erzeugt. Durch eine minimale Breite und minimalen Abstand der Bahnen, die aus der TEOS-Hilfsschicht erzeugt werden, erreicht man eine Selbstjustierung einer Wortleitung und durch einen etwas größeren Abstand der Bahnen in der anderen Richtung die Ausbildung einer Bitleitung. Dies kann beispielsweise durch Ausbildung der ersten Bahnen mit einer Breite α ∗ F (α > 1) und der zweiten Bahnen mit der minimalen Breite der Strukturfeinheit F geschehen.

Bevorzugt werden mit der erzeugten Ätzmaske Zylinder für 3-D Sidewall Flash EPROM Zellen hergestellt. Im Zuge des Herstellungsverfahrens werden die Kanten der Zylinder verrundet, so daß diese eine Säulenform erhalten. Diese Zellen bestehen aus vertikalen Zylindern und gewährleisten durch ihre vertikale Anordnung ebenfalls schon eine Erhöhung der Packungsdichte. Durch die Anwendung des erfindungsgemäßen Verfahrens lassen sich derart dünne Zylinder herstellen, daß diese vollständig verarmt, also ladungsträgerfrei sind.

Weiterhin besteht die Möglichkeit, die als Ätzmaske dienende Oxidschicht anschließend auch als Implantationsmaske zu verwenden. So könnte die zur Erzeugung der Zylinder dienende Maske auch noch für weitere Funktionen verwendet werden. Ebensogut ist es natürlich auch möglich, die maskierende Oxidschicht in gewohnter Weise zu entfernen.

Nachfolgend wird die Erfindung anhand eines in der Zeichnung dargestellten Ausführungsbeispiels weiter erläutert. Im einzelnen zeigen die schematischen Darstellungen in:
- Figur 1: einen Querschnitt durch das Halbleitersubstrat und die aufgebrachten Schichten zu Beginn des Verfahrens;
- Figur 2: einen Querschnitt durch das Halbleitersubstrat und die aufgebrachten Schichten in einem nachfolgenden Verfahrensschritt;
- Figur 3: eine Draufsicht der verfahrensmäßig bearbeiteten oberen Schichten mit den ersten Spacern;
- Figur 4: (a) eine Draufsicht und
(b) und (c) Querschnitte der verfahrensmäßig bearbeiteten oberen Schichten mit den zweiten erzeugten Spacern;
- Figur 5: (a) eine Draufsicht und
(b) und (c) Querschnitte des Halbleitersubstrats und der bearbeiteten oberen Schichten bei einem Verfahrensstand, in dem die Kreuzungsbereiche erzeugt sind; und
- Figur 6: einen Querschnitt durch das Halbleitersubstrat mit der daraufliegenden fertigen Ätzmaske.

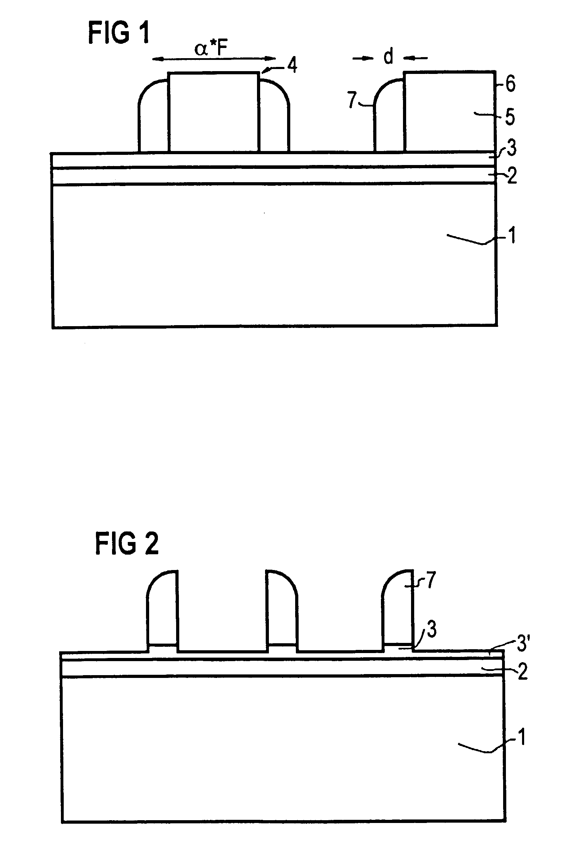

Der Herstellungsprozeß ist in den Figuren 1 bis 6 schematisch dargestellt und wird im folgenden anhand der Figuren beschrieben.

Figur 1 zeigt ein Halbleitersubstrat 1, welches in der Regel aus kristallinem Silizium besteht, mit einer darauf erzeugten oder abgeschiedenen Oxidschicht 2. Auf diese Schicht aus Siliziumoxid wird eine amorphe oder polykristalline Siliziumschicht 3 mit einer Dicke x abgeschieden. Darauf wird eine Hilfsschicht 4 vorzugsweise aus TEOS (Tetraethyloxysilikat) abgeschieden und strukturiert. Die Strukturierung erfolgt photolithografisch, wobei bestenfalls Strukturen mit der Strukturfeinheit F hergestellt werden können. Dabei werden Bahnen 5 erzeugt, die parallel zueinander ausgerichtet sind. An den Flanken 6 der Bahnen 5 wird dann ein Spacer 7 durch konforme Abscheidung und anschließende anisotrope Ätzung erzeugt. Der Spacer 7 weist eine Breite d auf, die günstigerweise der Dicke x der Siliziumschicht 3 entspricht. Die Spacer sind mit einer minimalen Breite von ungefähr 20 nm herstellbar. Die Spacer wiederholen sich in einem Abstand α ∗ F, wobei α größer als Eins ist. Der Spacer besteht aus einem Material wie beispielsweise Siliziumnitrid, welches sich selektiv zur Hilfsschicht und zur Unterlage ätzen läßt.

Als nächstes wird die TEOS-Hilfsschicht isotrop entfernt, wie in Figur 2 dargestellt ist. Der Spacer 7 dient jetzt als Maske für die erste anisotrope Ätzung der abgeschiedenen Siliziumschicht 3, bei der diese mindestens zur Hälfte, aber nicht vollständig geätzt wird. Vorzugsweise wird die Siliziumschicht zu 2/3 geätzt. Anschließend werden die ersten Spacer 7 entfernt, so daß an deren Stelle nur noch ein erhöhter Bereich der Siliziumschicht 3' stehen bleibt.

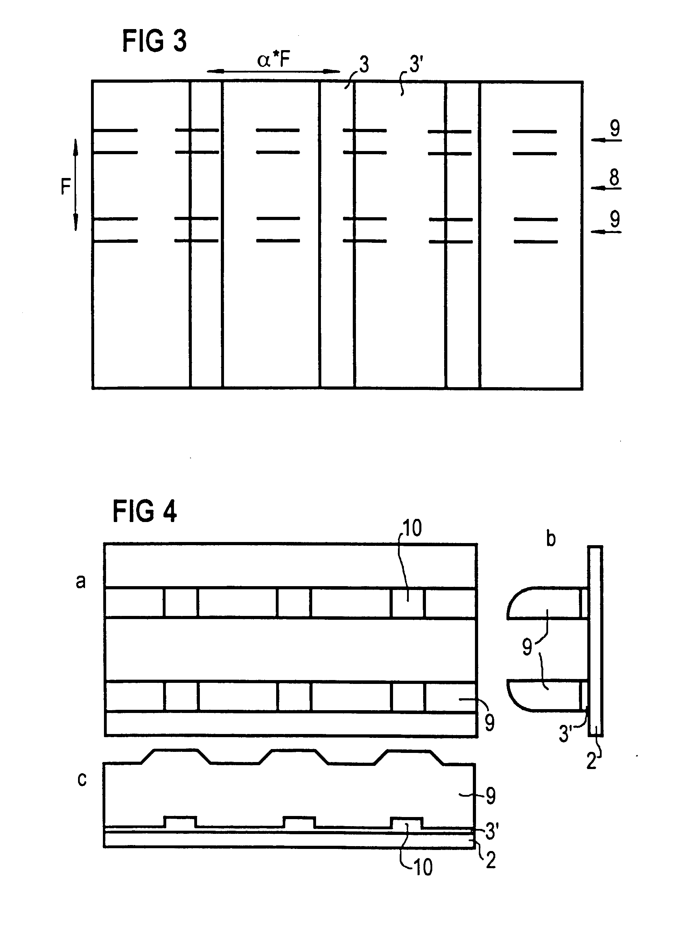

Diese Strukturierung ist in Figur 3 zu erkennen, in der an der Stelle der vorher mit der Hilfsschicht 4 bedeckten Bahnen die z.T. weggeätzte Siliziumschicht 3' vorhanden ist und an deren Seiten, an der Stelle der Spacer 7 die noch vollständig erhaltene Siliziumschicht 3 übriggeblieben ist. Im folgenden wird nun wieder eine Hilfsschicht aufgebracht, und orthogonal zur Richtung der ersten Bahnen werden Bahnen 8 durch Photolithographie erzeugt. An den Flanken der Bahnen 8 werden Spacer 9 durch Abscheidung und Ätzung erzeugt. Diese Spacer werden mit minimal möglichem Abstand F voneinander ausgebildet und sind in Fig. 3 gestrichelt dargestellt.

Nach Entfernen der Hilfsschicht und einer zweiten anisotropen Ätzung der Siliziumschicht 3', bei der die Siliziumschicht 3' außerhalb der zweiten Spacerstreifen 9 vollständig entfernt wird, erreicht man den in Figur 4 dargestellten Verfahrensstand. In Figur 4a ist eine Draufsicht dargestellt, in der außerhalb der zweiten Spacer 9 die Siliziumschicht 3' vollständig abgetragen ist, so daß dort die Oxidschicht 2 an der Oberfläche liegt. Im Bereich der zweiten Spacer ist die Siliziumschicht 3' noch zu einem Teil vorhanden, soweit er bei der ersten Ätzung nicht abgetragen wurde und ist im Kreuzungsbereich 10, an dem vorher die ersten Spacer 7 verliefen, sogar noch vollständig vorhanden. Figur 4c zeigt einen Querschnitt durch die Oxidschicht 2 und die Siliziumschicht 3' im Bereich eines zweiten Spacers 9. In Figur 4b ist ein Querschnitt in einer Richtung orthogonal zu den zweiten Spacern 9 dargestellt, der nicht durch den Kreuzungsbereich 10 verläuft.

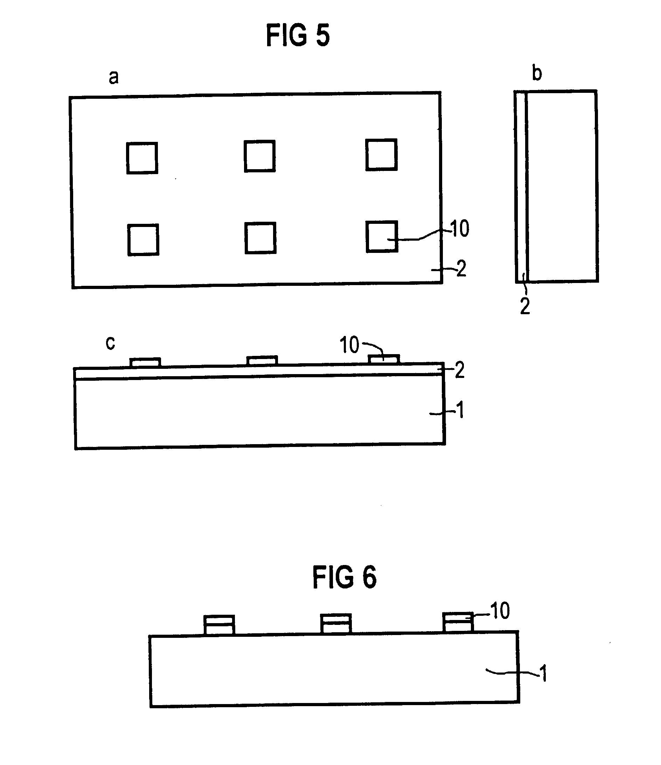

Anschließend werden die zweiten Spacer selektiv zu Silizium und Oxid isotrop entfernt. Es verbleiben die Siliziumstreifen mit Erhebungen an den Stellen der ersten Spacer. Mit einer weiteren ganzflächigen anisotropen Ätzung wird nun gerade soviel Silizium abgetragen, daß die Kreuzungsbereiche 10 beider Spacerlinien 7 und 9 nicht vollständig verschwinden, aber die Bereiche außerhalb der Kreuzungsbereiche 10 vollständig geätzt werden. Diese Situation ist in Figur 5 dargestellt. Figuren 5b und 5c stellen verschiedene Querschnitte durch die Draufsicht entsprechend Figur 5a dar. In Figur 5c ist zu erkennen, daß die Kreuzungsbereiche bis auf einen Rest abgeätzt worden sind, der genau dem Unterschied zwischen den erhöhten Kreuzungsbereichen 10 und der noch übrigen Schichtdicke der Siliziumschicht 3 in Figur 4c entspricht.

Diese Kreuzungsbereiche 10 aus Silizium werden nun als Ätzmaske für die darunter liegende Oxidschicht 2 benutzt, so daß eine Struktur gemäß dem Querschnitt in Figur 6 entsteht. Diese Kreuzungsbereiche aus Oxid dienen nun ihrerseits als Ätzmaske für die eigentliche tiefe Ätzung im Halbleitersubstrat 1 zur Erzeugung der aktiven Zylinder.

## Patentansprüche

1. Verfahren zur Herstellung von sublithographischen Ätzmasken bei Halbleiterprodukten mit hoher Integrationsdichte, bei dem
(a) auf einem Halbleitersubstrat (1) eine Oxidschicht (1) und darauf eine Siliziumschicht (3) erzeugt wird,
(b) auf der Siliziumschicht (3) eine Hilfsschicht (4) aufgebracht wird,
(c) die Hilfsschicht (4) bahnenweise strukturiert wird,
(d) an den Flanken (6) der so strukturierten Hilfsschicht (4) ein erster Spacer (7) erzeugt wird,
(e) die Hilfsschicht (4) entfernt wird,
(f) die Siliziumschicht (3) unter Verwendung des ersten Spacers (7) als Maske teilweise entfernt wird,
(g) der erste Spacer (7) entfernt wird, so daß an dessen Stelle ein erhöhter Bereich der Siliziumschicht (3) stehen bleibt,
dadurch gekennzeichnet, daß
(h) eine weitere Hilfsschicht aufgebracht und ebenfalls bahnenweise strukturiert wird, wobei diese zweiten Bahnen (8) in eine andere Richtung als die im Verfahrensschritt (c) strukturierten ersten Bahnen (5) ausgerichtet werden und sich mit diesen kreuzen,
(i) eine analoge Wiederholung der Schritte (d) bis (g) mit einem zweiten Spacer (9) durchgeführt wird, wobei erhöhte Kreuzungsbereiche (10) zwischen dem erhöhten Bereich der Siliziumschicht (3) und dem zweiten Spacer gebildet werden und wobei im zweiten Schritt (f) die Siliziumschicht unter Verwendung des zweiten Spacers als Maske vollständig entfernt wird,
(j) die vorher unter dem Spacer (9) befindliche Siliziumschicht (3), die im ersten Verfahrensschritt (f) bereits teilweise entfernt wurde, so weit entfernt wird, daß die Bereiche außerhalb der erhöhten Kreuzungsbereiche vollständig entfernt werden und von den erhöhten Kreuzungsbereichen (10) ein Rest verbleibt,
(k) die unter der Siliziumschicht (3) liegende Oxidschicht unter Verwendung der erhöhten Kreuzungsbereiche (10) als Maske strukturiert wird und
(l) die so geätzte Oxidschicht (2) als Ätzmaske für die eigentliche Strukturerzeugung genutzt wird.

2. Verfahren nach Anspruch 1,
dadurch **gekennzeichnet**,
daß die Hilfsschichten (4) durch Abscheidung von Siliziumoxid aus TEOS (Tetraethyloxysilikat) erzeugt werden.

3. Verfahren nach einem der vorhergehenden Ansprüche,
dadurch **gekennzeichnet**,
daß die Hilfsschichten (4) photolithografisch strukturiert werden.

4. Verfahren nach einem der vorhergehenden Ansprüchen,
dadurch **gekennzeichnet**,
daß die Spacer (7, 9) durch konforme Abscheidung von Nitrid an den Flanken (6) der jeweils strukturierten Hilfsschicht (4) und anschließende anisotrope Ätzung erzeugt werden.

5. Verfahren nach einem der vorhergehenden Ansprüche,
dadurch **gekennzeichnet**,
daß im ersten Schritt (f) die Siliziumschicht durch anisotrope Ätzung zu ca. 2/3 entfernt wird.

6. Verfahren nach einem der vorhergehenden Ansprüche,
dadurch **gekennzeichnet**,
daß die ersten Spacer (7) mit der gleichen Breite wie die zweiten Spacer (9) erzeugt werden.

7. Verfahren nach einem der vorhergehenden Ansprüche,
dadurch **gekennzeichnet**,
daß die ersten und zweiten Bahnen (5, 8) orthogonal zueinander ausgerichtet sind.

8. Verfahren nach einem der vorhergehenden Ansprüche,
dadurch **gekennzeichnet**,
daß die zweiten Bahnen (8) mit einer anderen Breite als die ersten Bahnen (5) erzeugt werden.

9. Verfahren nach einem der vorhergehenden Ansprüche,
dadurch **gekennzeichnet**,
daß mit der als Ätzmaske dienenden Oxidschicht Zylinder für 3-D Sidewall Flash EPROM Zellen hergestellt werden.

10. Verfahren nach einem der vorhergehenden Ansprüche,
dadurch **gekennzeichnet**,
daß die als Ätzmaske dienende Oxidschicht anschließend auch als Implantationsmaske verwendet wird.

## Claims

1. Method for fabricating sublithographic etching masks for semiconductor products with a high integration level, in which
(a) an oxide layer (2) is produced on a semiconductor substrate (1) and a silicon layer (3) is produced on top of the said oxide layer,
(b) an auxiliary layer (4) is applied on the silicon layer (3),
(c) the auxiliary layer (4) is patterned into tracks, (d) a first spacer (7) is produced on the sidewalls (6) of the auxiliary layer (4) which has been patterned in this way,
(e) the auxiliary layer (4) is removed,
(f) the silicon layer (3) is partly removed using the first spacer (7) as a mask,
(g) the first spacer (7) is removed, with the result that an elevated region of the silicon layer (3) remains in the place of the said spacer,
characterized in that
(h) a further auxiliary layer is applied and likewise patterned into tracks, these second tracks (8) being oriented in a different direction from the first tracks (5) patterned in method step (c) and intersecting with the said first tracks,
(i) an analogous repetition of steps (d) to (g) is carried out with a second spacer (9), elevated intersection regions (10) being formed between the elevated region of the silicon layer (3) and the second spacer, and, in the second step (f), the silicon layer being completely removed using the second spacer as a mask,
(j) the silicon layer (3) previously situated under the spacer (9), which silicon layer was already partly removed in the first method step (f), is removed to such an extent that the regions outside the elevated intersection regions are completely removed and a residue of the elevated intersection regions (10) remains,
(k) the oxide layer lying under the silicon layer (3) is patterned using the elevated intersection regions (10) as a mask, and
(l) the oxide layer (2) which has been etched in this way is used as an etching mask for the actual structure production.

2. Method according to Claim 1,
characterized
in that the auxiliary layers (4) are produced from TEOS (tetraethyl oxysilicate) by the deposition of silicon oxide.

3. Method according to one of the preceding claims,
characterized
in that the auxiliary layers (4) are patterned photolithographically.

4. Method according to one of the preceding claims,
characterized
in that the spacers (7, 9) are produced by the conformal deposition of nitride on the sidewalls (6) of the respectively patterned auxiliary layer (4) and subsequent anisotropic etching.

5. Method according to one of the preceding claims,
characterized
in that, in the first step (f), the silicon layer is removed by approximately 2/3 by means of anisotropic etching.

6. Method according to one of the preceding claims,
characterized
in that the first spacers (7) are produced with the same width as the second spacers (9).

7. Method according to one of the preceding claims,
characterized
in that the first and second tracks (5, 8) are oriented orthogonally with respect to one another.

8. Method according to one of the preceding claims,
characterized
in that the second tracks (8) are produced with a different width from the first tracks (5).

9. Method according to one of the preceding claims,
characterized
in that cylinders for 3-D Sidewall Flash EPROM cells are fabricated with the oxide layer serving as an etching mask.

10. Method according to one of the preceding claims,
characterized
in that the oxide layer serving as an etching mask is subsequently used as an implantation mask as well.

## Revendications

1. Procédé de fabrication de masques de gravure sublithographiques, dans des produits semi-conducteurs à grande densité d'intégration, dans lequel
(a) on produit une couche d'oxyde (1) sur un substrat semi-conducteur (1) et, par dessus, une couche de silicium (3),
(b) on applique sur la couche de silicium (3) une couche auxiliaire (4),
(c) on structure en bandes la couche auxiliaire (4),
(d) on produit un premier espaceur (7) sur les flancs (6) de la couche auxiliaire (4) ainsi structurée,
(e) on enlève la couche auxiliaire (4),
(f) on enlève partiellement la couche de silicium (4) en utilisant en tant que masque le premier espaceur (7),
(g) on enlève le premier espaceur (7) de façon qu'il reste à sa place une zone surélevée de la couche de silicium (3),
caractérisé en ce que
(h) on dépose une autre couche auxiliaire et on la structure elle aussi en bandes, ces deuxièmes bandes (8) étant orientées dans une direction différente de celle des premières bandes (5) structurées dans l'étape (c) et s'entrecroisant avec ces dernières,
(i) on procède à une répétition analogue des étapes (d) à (g) avec un deuxième espaceur (9), des zones d'intersection surélevées (10) étant formées entre la zone surélevée de la couche de silicium (3) et le deuxième espaceur, la couche de silicium étant entièrement enlevée dans la deuxième étape (f) par utilisation, en tant que masque, du deuxième espaceur,
(j) on enlève la couche de silicium (3), se trouvant au préalable en-dessous de l'espaceur (9) et qui a été déjà partiellement enlevée au cours de la première étape (f), jusqu'à ce que les zones extérieures aux zones d'intersection surélevées soient entièrement enlevées, et qu'il reste une partie des zones d'intersection surélevées (10),
(k) on structure la couche d'oxyde située en-dessous de la couche de silicium (3), en utilisant en tant que masque les zones d'intersection surélevées (10), et
(I) on utilise en tant que masque de gravure la couche d'oxyde (2) ainsi gravée, pour la production proprement dite de structures.

2. Procédé selon la revendication 1, caractérisé en ce que les couches auxiliaires (4) sont obtenues par déposition d'un oxyde de silicium obtenu à partir de TEOS (oxysilicate de tétraéthyle).

3. Procédé selon l'une des revendications précédentes, caractérisé en ce que les couches auxiliaires (4) sont structurées par photolithographie.

4. Procédé selon l'une des revendications précédentes, caractérisé en ce que les espaceurs (7, 9) sont produits par déposition conforme de nitrure sur les flancs (6) de chaque couche auxiliaire structurée (4), puis par une gravure anisotrope.

5. Procédé selon l'une des revendications précédentes, caractérisé en ce que la couche de silicium est enlevée approximativement aux 2/3 dans la première étape (f) par gravure anisotrope.

6. Procédé selon l'une des revendications précédentes, caractérisé en ce que les premiers espaceurs (7) sont produits avec la même largeur que les deuxièmes espaceurs (9).

7. Procédé selon l'une des revendications précédentes, caractérisé en ce que les premières et les deuxièmes bandes (5, 8) sont orientées orthogonalement les unes aux autres.

8. Procédé selon l'une des revendications précédentes, caractérisé en ce que les deuxièmes bandes (8) sont produites avec une largeur différente de celle des premières bandes (5).

9. Procédé selon l'une des revendications précédentes, caractérisé en ce qu'on produit avec la couche d'oxyde servant de masque de gravure des cylindres destinés à des cellules EPROM 3-D Sidewall Flash.

10. Procédé selon l'une des revendications précédentes, caractérisé en ce que la couche d'oxyde servant de masque de gravure est ensuite utilisée aussi en tant que masque d'implantation.
